# EUROPÄISCHE PATENTSCHRIFT

(11) **EP 0 769 809 B1**
(45) Veröffentlichungstag und Bekanntmachung des Hinweises auf die Patenterteilung: **27.12.2006**
(21) Anmeldenummer: 96116011.6
(22) Anmeldetag: 07.10.1996
(51) Int. Cl.: H01L 21/322, C30B 33/00, H01L 21/316

(54) **Verfahren zum Beseitigen von Kristallfehlern in Siliziumscheiben**
Process for suppressing crystalline defects in silicon wafers
Procédé de suppression de défauts cristallins dans des plaquettes de silicium

(30) Priorität: 19.10.1995 DE 19538983
(43) Veröffentlichungstag der Anmeldung: 23.04.1997
(73) Patentinhaber: Infineon Technologies AG, 81669 München (DE)
(72) Erfinder: Schulze, Hans-Joachim, Dr., 85521 Ottobrunn (DE)
(74) Vertreter: Bickel, Michael

(56) Entgegenhaltungen:
- DE-A- 4 323 964
- IEEE TRANSACTIONS ON NUCLEAR SCIENCE, Bd. 36, Nr. 1, 1.Februar 1989, Seiten 290-294, XP000111985 LI Z ET AL: "GETTERING IN HIGH RESISTIVE FLOAT ZONE SILICON WAFERS FOR SILICON DETECTOR APPLICATIONS"
- MATERIALS SCIENCE FORUM; 18TH. INTERNATIONAL CONFERENCE ON DEFECTS IN SEMICONDUCTORS, ICDS-18, SENDAI, JAPAN, Bd. 196-201, 23. - 28.Juli 1995, Seiten 1697-1706, XP000195829 J.-G. PARK ET AL.: "Nature of D-defect in CZ Silicon: D-defect dissolution and D-defect related T.D.D:B."
- PATENT ABSTRACTS OF JAPAN vol. 008, no. 213 (E-269), 28.September 1984 & JP 59 099727 A (TOSHIBA KK), 8.Juni 1984,
- PATENT ABSTRACTS OF JAPAN vol. 007, no. 233 (E-204), 15.Oktober 1983 & JP 58 121631 A (TOKYO SHIBAURA DENKI KK), 20.Juli 1983, & JP 58 121 631 A (TOKYO SHIBAURA DENKI K.K.) 20.Juli 1983
- DEFECTS IN SEMICONDUCTORS II; MATERIALS RESEARCH SOCIETY SYMPOSIUM PROCEEDINGS, Bd. 14, 1983, Seiten 87-93, XP000195832 GOBINDA DAS: "Direct evidence of diffusion of self interstitials in silicon"
- APPLIED PHYSICS LETTERS, Bd. 64, Nr. 8, 21.Februar 1994, Seiten 1030-1032, XP000425895 WIJARANAKULA W ET AL: "EFFECT OF HIGH-TEMPERATURE ANNEALING ON THE DISSOLUTION OF THE D-DEFECTS IN N-TYPE CZOCHRALSKI SILICON"

## Beschreibung

Die Erfindung bezieht sich auf ein Verfahren zum Beseitigen von Kristalldefekten in aus Stäben gewonnenen Siliziumscheiben, in die bei einer vorgegebenen Temperatur Dotierstoffe eindiffundiert werden.

Leistungs-Halbleiterbauelemente wie Thyristoren, GTO-Thyristoren und Dioden verwenden Halbleiterscheiben, die aus gezogenen monokristallinen Siliziumstäben z.B. durch Absägen gewonnen werden. Analysen an solchen Halbleiterscheiben haben ergeben, dass im zentralen Bereich der Scheiben eine deutlich erhöhte Defektdichte vorhanden ist. Bei diesen Defekten handelt es sich mit hoher Wahrscheinlichkeit um Leerstellenagglomerate, die durch den Ziehprozess des Kristalls verursacht werden. Werden in solche Halbleiterscheiben bei hoher Temperatur, z.B. 1240 DEG C, Dotierstoffe eindiffundiert, können sich an diese Defekte Schwermetalle anlagern. Dadurch entstehen tief im Siliziumenergieband liegende Störstellen, die zu einer erheblich reduzierten Ladungsträgerlebensdauer im zentralen Scheibenbereich führen.Dies hat insbesondere bei Leistungs-Halbleitern, die gegen über anderen Halbleiterbauelementen deutlich höhere Siliziumdicken und erheblich tiefere Raumladungszonen aufweisen, stark erhöhte Sperrströme zur Folge.

In Li et al.: "Gettering in High Resistive Float Zone Silicon Wafers for Silicon Detector Applications", IEEE Transactions on Nuclear Science, Band 36, Nr. 1, Februar 1998, Seiten 290 bis 294, ist ein Verfahren zur Behandlung von Halbleiterwafern beschreiben, bei dem der Wafer einer dreistufigen Oxidation unterzogen wird. In einem ersten Oxidationsschritt wird der Wafer für eine Dauer von sechs Stunden in einer TCA (Trichlorethan)-Sauerstoff-Atmosphäre auf eine Temperatur von 1170°C aufgeheizt. Während dieser Oxidation werden interstitielle Siliziumatome aus dem Halbleiterwafer entfernt und Leerstellen werden in den Halbleiterwafer eingebracht.

Das Dokument J.G. Park et al., "Nature of D-Defect in CZ Silicon: D-Defect Dissolution and D-Defect related T.D.D.B." Materials Science Forum Vols. 196 - 201, Seiten 1697 - 1706, wurde am 5. November 1995 Veröffentlicht, in einem Tagungsband zu einer vom 23. bis 28. Juli 1995 in Senda, Japan, stattgefundenen Konferenz, und beschreibt ein Verfahren bei dem eine Si-Scheibe für eine Dauer von 2 Stunden in einer Sauerstoff-Atmosphäre auf eine Temperatur von 1200°C trockenoxidiert wird, um D-Defekten zu beseitigen.

Der Erfindung liegt die Aufgabe zugrunde, ein Verfahren der angegebenen Art anzugeben, mit dem die genannten Defekte nachträglich an der Siliziumscheibe beseitigt werden können.

Diese Aufgabe wird dadurch gelöst, dass die Halbleiterscheiben vor dem Eindiffundieren der Dotierstoffe oberflächlich bei einer solchen Temperatur oxidiert werden, dass hierdurch erzeugte interstitielle Siliziumatome von beiden Seiten der Siliziumoberfläche bis in eine Scheibentiefe eindiffundieren, die mindestens der halben Scheibendicke entspricht.

Die Halbleiterscheiben können z.B. entweder in feuchter Luft oxidiert werden oder in einer sauerstoffhaltigen, gasförmigen Dotierstoffverbindung. Als letzte kommt z.B. Phosphoroxy-Trichlorid (POCl₃) in Frage.

Die Oxidation wird bei einer Temperatur zwischen 1100 und 1180°C für eine Zeit zwischen 2 und 5 Stunden durchgeführt. Messungen haben gezeigt, daß die genannten Defekte im zentralen Bereich der Scheibe z.B. durch eine feuchte Oxidation bei T=1150°C für eine Zeitdauer von 3 Stunden weitgehend beseitigt werden konnten. Bei einer POCl₃-Diffusion konnte eine Beseitigung der Defekte z.B. bei einer Temperatur von T=1150°C und einer Zeitdauer von 2,5 Stunden beobachtet werden.

Die Beseitigung der Kristalldefekte läßt sich vermutlich dadurch erklären, daß bei der oberflächlichen Oxidation des Siliziums an der Grenzfläche Silizium/Oxid interstitielles Silizium gebildet wird. Dieses Silizium gelangt durch Zwischengitterdiffusion sehr schnell in das Innere der Siliziumscheibe. Dort besetzt es die Fehlstellen im Kristallgitter, so daß bei nachfolgenden Hochtemperaturschritten Schwermetalle keine Möglichkeit mehr haben, sich hier anzulagern.

Bei der Diffusion mit POCl₃ ist es i.a. erforderlich, die entstandene mit Phosphor dotierte Zone durch Abätzen zu entfernen. Da hierdurch aber die Dicke der Siliziumscheiben merklich reduziert wird, sollte in diesem Fall die Ausgangsdicke der Siliziumscheiben entsprechend erhöht werden.

Einfacher ist die Variante, die Defekte mit Hilfe der feuchten Oxidation auszuheilen. Es empfiehlt sich i.a., die Oxidschicht vor dem Eindiffundieren der Dotierstoffe zu entfernen. Sie ist ca. 1 µm dick und kann problemlos in einem Flußsäurebad wieder abgelöst werden. Anschließend an die Oxidation und das Entfernen der Oxidschicht werden die für die Herstellung eines Thyristors oder einer Diode benötigten Dotierstoffe wie Phosphor, Bor, Gallium, Aluminium etc. bei einer i.a. höheren Temperatur, z. B. 1240°C eindiffundiert.

Das beschriebene Verfahren hat sich bei Siliziumscheiben gut bewährt, die von einem in "Float-Zone"-Technik hergestellten Siliziumstab abgeschnitten wurden. Die Erfindung läßt sich jedoch auch bei Siliziumscheiben anwenden, die von einem Siliziumstab abgeschnitten sind, der nach dem Czochralski-Verfahren (Tiegel-Verfahren) hergestellt wurde.

## Patentansprüche

1. Verfahren zum Beseitigen von Kristalldefekten in einer aus einem Stab gewonnenen Siliziumscheibe, in die bei einer vorgegebenen Temperatur Dotierstoffe eindiffundiert werden,
**dadurch gekennzeichnet, dass** die Siliziumscheibe vor oder während dem Eindiffundieren der Dotierstoffe oberflächlich derart bei einer Temperatur zwischen 1100°C und 1180°C und bei einer Zeit zwischen 2 und 5 Stunden oxidiert wird, dass hierdurch erzeugte interstitielle Siliziumatome von beiden Seiten der Siliziumscheibe bis in eine Scheibentiefe eindiffundieren, die mindestens der halben Scheibendicke entspricht, und die Fehlstellen im Kristallgitter besetzt.

2. Verfahren nach Anspruch 1,
**dadurch gekennzeichnet, dass** die Siliziumscheibe in feuchter Luft oxidiert wird.

3. Verfahren nach Anspruch 1,
**dadurch gekennzeichnet, dass** die Siliziumscheibe in einer sauerstoffhaltigen, gasförmigen Dotierstoffverbindung oxidiert wird und dass eine hierbei entstehende dotierte zone durch Abätzen wieder entfernt wird.

4. Verfahren nach Anspruch 3,
**dadurch gekennzeichnet, dass** die Dotierstoffverbindung Phosphoroxy-Trichlorid (POCl₃) ist.

5. Verfahren nach einem der Ansprüche 1 oder 2,
**dadurch gekennzeichnet, dass** die Oxidschicht vor dem Eindiffundieren der Dotierstoffe entfernt wird.

## Claims

1. Method for eliminating crystal defects in a silicon wafer which is obtained from a rod and into which dopants are indiffused at a predetermined temperature,
**characterized in that** the silicon wafer is superficially oxidized before or during the indiffusion of the dopants at a temperature of between 1100°C and 1180°C and for a time of between 2 and 5 hours in such a way that interstitial silicon atoms produced as a result indiffuse from both sides of the silicon wafer down to a wafer depth which corresponds to at least half of the wafer thickness, and occupies the imperfections in the crystal lattice.

2. Method according to Claim 1,
**characterized in that** the silicon wafer is oxidized in moist air.

3. Method according to Claim 1,
**characterized in that** the silicon wafer is oxidized in an oxygen-containing, gaseous dopant compound, and **in that** a doped zone arising in this case is removed again by being etched away.

4. Method according to Claim 3,
**characterized in that** the dopant compound is phosphorus oxytrichloride (POCl₃).

5. Method according to either of Claims 1 and 2,
**characterized in that** the oxide layer is removed prior to the indiffusion of the dopants.

## Revendications

1. Procédé de suppression de défauts cristallins dans une plaquette de silicium obtenue à partir d'une barre, dans laquelle des impuretés de dopage sont diffusées à une température prédéterminée,
**caractérisé en ce que**
la plaquette de silicium est oxydée superficiellement, avant ou pendant la diffusion des impuretés de dopage, à une température de 1100°C à 1180°C et pendant un temps de 2 à 5 heures, de telle façon que les atomes interstitiels de silicium ainsi obtenus diffusent à partir des deux faces de la plaquette de silicium jusqu'à une profondeur de celle-ci qui est égale au moins à la moitié de son épaisseur et qui possède des emplacements défectueux dans le réseau cristallin.

2. Procédé selon la revendication 1,
**caractérisé en ce que**
la plaquette de silicium est oxydée dans l'air humide.

3. Procédé selon la revendication 1,
**caractérisé en ce que**
la plaquette de silicium est oxydée dans un composé gazeux d'impuretés de dopage, contenant de l'oxygène, et une zone dopée ainsi obtenue est ensuite éliminée par décapage.

4. Procédé selon la revendication 3,
**caractérisé en ce que**
le composé d'impuretés de dopage est de l'oxytrichlorure de phosphore (POCl₃).

5. Procédé selon l'une des revendications 1 ou 2,
**caractérisé en ce que**
la couche oxydée est éliminée avant la diffusion des impuretés de dopage.
